**Europäisches Patentamt**

**European Patent Office**

**Office européen des brevets**

(19)

(11) Veröffentlichungsnummer: **0 049 517**
**B1**

(12) **EUROPÄISCHE PATENTSCHRIFT**

(45) Veröffentlichungstag der Patentschrift:
**24.09.86**

(21) Anmeldenummer: **81107984.7**

(22) Anmeldetag: **06.10.81**

(51) Int. Cl.⁴: **H 05 K 5/06,** H 05 K 7/18,
H 05 K 9/00

(54) Gehäuse mit Einschub für Geräte der elektrischen Nachrichtentechnik.

(30) Priorität: **08.10.80 DE 3038074**

(43) Veröffentlichungstag der Anmeldung:
**14.04.82 Patentblatt 82/15**

(45) Bekanntmachung des Hinweises auf die Patenterteilung:
**24.09.86 Patentblatt 86/39**

(84) Benannte Vertragsstaaten:
**GB NL SE**

(56) Entgegenhaltungen:
**DE-A-2 443 122**
**DE-A-2 652 082**
**DE-B-2 348 687**

(73) Patentinhaber: **Siemens Aktiengesellschaft Berlin und München, Wittelsbacherplatz 2, D-8000 München 2 (DE)**

(72) Erfinder: **Gstöttenbauer, Jakob, Ing.- grad., Keltenstrasse 26, D-8029 Sauerlach (DE)**
Erfinder: **Ebert, Alfred, Ing.- grad., Noestrasse 30, D-8000 München 71 (DE)**

LIBER, STOCKHOLM 1986

## Description

Die Erfindung bezieht sich auf ein Gehäuse mit Einschub für Geräte der elektrischen Nachrichtentechnik, das mit elektrischen Steckvorrichtungen für den Einschub versehen ist und dessen Seitenwände mit nach außen abragenden Ansätzen für Schraubverbindungen versehen sind. Ein derartiges Gehäuse geht aus der DE-OS 24 43 122 als bekannt hervor.

Aus dieser Druckschrift ist ein Gerät für die Hochfrequenz- und Nachrichtentechnik mit übereinander gestapelten wasserdichten Gehäusen bekannt, wobei die einzelnen, für Steckbaugruppen vorgesehenen Gehäuse aus einem rahmenförmigen, an der Front- und der Rückseite offenen Kasten bestehen, der an den beiden offenen Seiten durch wannenförmige Deckel abgeschlossen ist. Bei einer Stapelanordnung sind somit für jedes Gehäuse jeweils zwei Deckel vorgesehen. Außerdem ist jedes Gehäuse mit einer zur Stapelung geeignet ausgebildeten oberen Deckwand abgeschlossen, welche bei einer Stapelung mit dem entsprechend ausgebildeten Boden eines aufgesetzten Gehäuses zusammenwirkt.

Der Erfindung liegt nun die Aufgabe zugrunde, bei einem Gehäuse der eingangs genannten Art, das eine beliebige Stapelung und jederzeit sowohl bei Verwendung als Einzelgehäuse als auch bei einer Anordnung von mehreren gestapelten Gehäusen eine leichte Zugänglichkeit und Auswechselbarkeit von Einschüben ermöglicht, einen möglichst einfachen Gehäuseaufbau zu erreichen. Da Gehäuse für Geräte der elektrischen Nachrichtentechnik, z.B. für Funkgeräte, auch im Freien eingesetzt werden, soll sowohl für das Einzelgehäuse als auch für eine Stapelanordnung Wasserdichtigkeit gewährleistet sein.

Diese Aufgabe wird bei einem Gehäuse der eingangs genannten Art gemäß der Erfindung durch folgende Merkmale gelöst:

a) das Gehäuse besteht aus einem Kasten mit einem durchgehenden Boden, zwei einander gegenüberliegenden Seitenwänden und einer Rückwand,

b) das Gehäuse ist über die Schraubverbindungen an der dem Boden gegenüberliegenden offenen Oberseite mit einem Deckel oder einem gleich ausgebildeten Boden eines aufgesetzten weiteren Gehäuses verbindbar,

c) das Gehäuse ist mit einer parallel zur Rückwand verlaufenden Zwischenwand ausgebildet, an der die elektrischen Steckvorrichtungen für den Einschub angeordnet sind,

d) die Zwischenwand ist mit einem rundumlaufenden, die Steckvorrichtungen gemeinsam umgebenden Kragen für eine Dichtschnur versehen, die zusammen mit einem entsprechenden Kragen um die Steckvorrichtungen des Einschubs dichtend wirksam ist,

e) die durch den Boden, die Seitenwände, die Rückwand und die Zwischenwand sowie den aufgeschraubten Deckel bzw. den Boden eines aufgesetzten weiteren Gehäuses gebildete Kammer ist durch in Nuten des zunächst offenen Randes des Gehäuses angeordnete Dichtschnüre gegen Wasser und gegebenenfalls gegen elektromagnetische Felder abgedichtet.

Ein auf diese Weise ausgebildetes Gehäuse ermöglicht eine beliebige Stapelung von solchen Gehäusen übereinander. Dabei besteht jedes Einzelgehäuse lediglich aus Boden, zwei Seitenwänden und einer Rückwand, so daß sich ein besonders einfacher Gehäuseaufbau mit einem nach vorne zum Einführen des Einschubs und nach oben offenen Kasten als Einschubträger ergibt. Die offene Oberseite eines Gehäuses wird im Falle eines Einzelgehäuses durch einen Deckel und im Falle einer aus mehreren Einzelgehäusen bestehenden Stapelanordnung jeweils durch Aufsetzen eines weiteren Gehäuses abgedeckt, so daß sowohl für den Fall einer Stapelanordnung als auch für den Fall eines Einzelgehäuses nur ein einziger Deckel zur Abdeckung der obersten offenen Gehäuseseite erforderlich ist. Da der Einschubträger sowohl im Falle des Einzelgehäuses als auch im Falle der Stapelanordnung zunächst nach vorne hin offen und somit zugänglich ist, sind Einschübe jederzeit leicht zugänglich und auswechselbar. Die erfindungsgemäße Ausbildung eines Gehäuses ist auch im Hinblick auf eine bei Einsatz im Freien erforderliche Abdichtung von Vorteil, da diese gleichzeitig mit dem Aufsetzen eines weiteren Gehäuses oder eines Deckels bewirkt werden kann.

Vorteilhafte Ausgestaltungen des Gegenstandes des Patentanspruchs 1 sind in den Unteransprüchen angegeben.

Ein Ausführungsbeispiel eines erfindungsgemäßen Gehäuses ist im folgenden anhand der Zeichnung näher beschrieben.

Fig. 1 zeigt in perspektivischer Darstellung eine Anordnung mit zwei übereinandergestapelten Gehäusen für zwei Einschübe,

Fig. 2 zeigt den Aufbau eines einzelnen Gehäuses ohne Einschub.

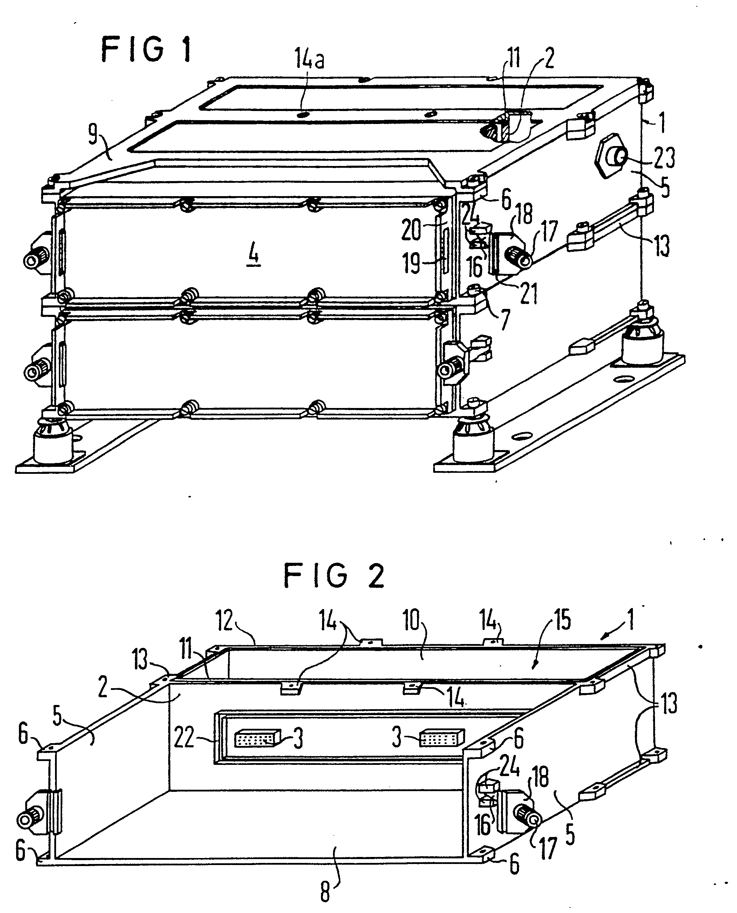

Ein Einzelgehäuse 1 (Fig.2) besteht aus einem Kasten mit einem durchgehenden Boden 8, zwei einander gegenüberliegenden Seitenwänden 5, einer Rückwand 10 und einer hierzu parallelen Zwischenwand 2, an der elektrische Steckvorrichtungen 3 für einen Einschub 4 angeordnet sind. Die Zwischenwand 2 ist bis zum oberen Rand 12 des Gehäuses 1 hochgezogen und bildet eine rückwärts liegende Kammer 15, welche durch in Nuten 11 des zunächst offenen Randes 12 des Gehäuses angeordnete Dichtschnüre gegen Wasser und gegebenenfalls gegen elektromagnetische Felder abgedichtet ist. Die Seitenwände 5 des Gehäuses 1 sind mit nach außen ragenden Ansätzen 6 für Schraubverbindungen 7 versehen, wobei das Gehäuse, wie Fig.1 zeigt, über die Schraubverbindungen an der dem Boden 8

gegenüberliegenden offenen Oberseite mit einem Deckel 9, der hier im Ausführungsbeispiel frontseitig einen Ausschnitt hat, oder einem gleich ausgebildeten Boden 8 eines aufgesetzten weiteren Gehäuses verbindbar ist. Bei der Verbindung zweier Gehäuse 1 oder eines Gehäuses 1 mit einem Deckel 9 preßt sich der Boden 8 bzw. der Deckel 9 gegen die in den Nuten 11 liegenden Dichtschnüre.

Im Bereich der Umrandung der Kammer 15 sind die Ansätze 13 flanschartig erweitert, um einen besseren Anpreßdruck erzeugen zu können. Zusätzliche Ansätze 14 können im Bereich der Zwischen- und Rückwand angeordnet und mit dem Deckel 9 bzw. einem Boden 8 verschraubt werden (Verschraubungen 14a). Der Einschub 4 selbst ist in einer üblichen Bauweise wasserdicht ausgeführt und hat rückseitig Steckelemente, die in die elektrischen Steckvorrichtungen 3 als Gegensteckelemente auf der Zwischenwand 2 eingreifen. Diese Gegensteckelemente haben ringsum einen Kragen 22, in dem eine Dichtschnur liegt. Ein entsprechender Kragen um die Steckelemente am Einschub sorgt nach vollständigem Einschieben für Wasserdichtung. Vorteilhaft ist es, wenn mehrere Steckereinheiten vorgesehen sind, um diese an einem gemeinsamen, diese umgreifenden Kragen 22 auf der Zwischenwand 2 zu befestigen, der die Dichtschnur enthält. Ein entsprechender Kragen befindet sich dann an der Rückseite des Einschubs, der die dortigen Steckelemente gesamt umgibt.

Die abgedichtete rückwärtige Kammer 15 ist für gerätespezifische Zusatzgeräte, z.B. Netzgeräte oder dergleichen, vorgesehen und erforderlichenfalls zur Verdrahtung von mehreren Gehäusen untereinander über Durchführungen durch die Böden. Ferner sind Leitungsverbindungen nach außen hier untergebracht, wie in Fig. 1 die Anschlußstecker 23 erkennen lassen.

Der Gehäuseblock kann gegen Stöße, wie im Ausführungsbeispiel dargestellt, durch Schwingmetalle gegen den Boden abgestützt werden.

Um eine Erleichterung für das Eindrücken und Ausziehen des Einschubs 4 zu schaffen und eine gute Dichtung für die Steckelemente, ist an beiden Seiten der Einschubfrontplatte eine Arretiervorrichtung vorgesehen.

Der Einschub, dessen rückseitige Steckvorrichtungen wie üblich ausgebildet und daher nicht dargestellt sind, ist dabei in einen Einschubrahmen eingeschoben. Er trägt an seiner Frontplatte einen rund umlaufenden Schutzkragen 20 für hervorstehende Bedienungselemente. In diesem Ausführungsbeispiel sind die Arretierungen an der Seite vorgesehen. Der seitliche Kragen 20 hat daher einen Schlitz 19 zur Aufnahme eines Nockens 18. Dieser Nocken 18 ist drehbar in einer Rändelmutter 17 gehalten. Die Rändelmutter 17 ist auf eine kippbare Gewindespindel 16 aufgeschraubt. Als Scharnier dienen dabei Laschen 24 an der Seitenwand 5 des Gehäuses 1. Nuten 21 im Nocken sind so ausgebildet, daß sie bei der Betätigung der Arretiervorrichtung den jeweiligen Rand des Schlitzes 19 umgreifen.

Beim Einschwenken des Nockens 18 in den Schlitz 19 läßt sich ein in beiden Richtungen der Einschubbewegung wirkender Kraftschluß zwischen Mutter und Einschub erzielen. Dieser erleichtert besonders in den Anfangs- und Endphasen die Steckkräfte.

**Patentansprüche**

1. Gehäuse (1) mit Einschub (4) für Geräte der elektrischen Nachrichtentechnik, das mit elektrischen Steckvorrichtungen (3) für den Einschub (4) versehen ist, und dessen Seitenwände (5) mit nach außen abragenden Ansätzen (6) für Schraubverbindungen (7) versehen sind, gekennzeichnet durch folgende Merkmale.

a) das Gehäuse (1) besteht aus einem Kasten mit einem durchgehenden Boden (8), zwei einander gegenüberliegenden Seitenwänden (5) und einer Rückwand (10),

b) das Gehäuse (1) ist über die Schraubverbindungen (7) an der dem Boden (8) gegenüberliegenden offenen Oberseite mit einem Deckel (9) oder einem gleich ausgebildeten Boden (8) eines aufgesetzten weiteren Gehäuses verbindbar, c) das Gehäuse (1) ist mit einer parallel zur Rückwand (10) verlaufenden Zwischenwand (2) ausgebildet, an der die elektrischen Steckvorrichtungen (3) für den Einschub (4) angeordnet sind,

d) die Zwischenwand (2) ist mit einem rundumlaufenden, die Steckvorrichtungen (3) gemeinsam umgebenden Kragen (22) für eine Dichtschnur versehen, die zusammen mit einem entsprechenden Kragen um die Steckvorrichtungen des Einschubs (4) dichtend wirksam ist,

e) die durch den Boden (8), die Seitenwände (5), die Rückwand (10) und die Zwischenwand (2) sowie den aufgeschraubten Deckel (9) bzw. den Boden (8) eines aufgesetzten weiteren Gehäuses gebildete Kammer (15) ist durch in Nuten (11) des zunächst offenen Randes (12) des Gehäuses (1) angeordnete Dichtschnüre gegen Wasser und gegebenenfalls gegen elektromagnetische Felder abgedichtet.

2. Gehäuse nach Anspruch 1; dadurch gekennzeichnet, daß der Einschub (4) selbst und seine Steckvorrichtungen durch Dichtschnüre abgedichtet sind.

3. Gehäuse nach einem der vorhergehenden Ansprüche, dadurch gekennzeichnet, daß im Bereich der Kammerdichtung die seitlichen Ansätze (13) an den Seitenwänden (5) flanschförmig erweitert sind.

4. Gehäuse nach einem der vorhergehenden Ansprüche, dadurch gekennzeichnet, daß an der Rückwand (10) und an der Zwischenwand (2) weitere, nach außen bzw. zum Einschub (4) hin abragende Ansätze (14) für Schraubverbindungen (14a) vorgesehen sind.

5. Gehäuse nach einem der vorhergehenden Ansprüche, dadurch gekennzeichnet, daß die Kammer (15) des Gehäuses (1) zur Aufnahme gerätespezifischer Zusatzelektronik und bei Verwendung mehrerer Gehäuse, zur Aufnahme von Verbindungen zwischen mehreren solchen Kammern sowie zur Aufnahme von dichten Verbindungen wie Anschlußsteckern (23) nach außen vorgesehen ist.

6. Gehäuse nach einem der vorhergehenden Ansprüche, dadurch gekennzeichnet, daß außen an den beiden Seitenwänden (5) des Gehäuses (1) scharnierartig befestigte Gewindespindeln (16) vorgesehen sind, die unverlierbare Rändelmuttern (17) tragen, die ihrerseits wieder formschlüssig und drehbar mit je einem nockenförmigen Teil (18) verbunden sind, der nach Einschwenken der Gewindespindel in einen seitlichen Schlitz (19) eines Kragens (20) am Einschub (4) mittels Nuten (21) eingreift.

## Claims

1. A case (1) with a drawer (4) for apparatus of electric communication technology, which is provided with electric plug devices (3) for the drawer (4), and whose lateral walls (5) are provided with outwardly projecting attachments (6) for screw connections (7), characterised by the following features:

a) the case (1) consists of a box with a continuous base (8), two oppositely arranged walls (5) and a rear wall (10),

b) the case (1) can be connected to a cover (9) or a similarly designed base (8) of a superimposed further case by means of screw, connections (7) on the open top side opposite the base (8),

c) the case (1) has an intermediate wall (2) which runs parallel to the rear wall (10) and on which the electric plug connections (3) for the drawer (4) are arranged,

d) the intermediate wall (2) is provided with a circulating collar (22), which commonly surrounds the plug devices (3), for a sealing cord which together with a corresponding collar around the plug devices of the drawer (4) is effective in a sealing fashion,

e) the chamber (15) which is formed by the base (8), the lateral walls (5), the rear wall (10) and the intermediate wall (2) and the screwed-on cover (9) or the base (8) of a superimposed further case is sealed from water and possibly from electro-magnetic fields by sealing cords arranged in grooves (11) of the firstly open edge of the case (1).

2. A case as claimed in Claim 1, characterised in that the drawer (4) itself and its plug devices are sealed by sealing cords.

3. A case as claimed in one of the preceding Claims, characterised in that in the region of the chamber seal the lateral attachments (13) on the lateral walls (5) are widened so as to be flange-shaped.

4. A case as claimed in one of the preceding Claims, characterised in that on the rear wall (10) and on the intermediate wall (2) there are arranged for screw connections (14a) further attachments (14) which project outwards or towards the drawer (4).

5. A case as claimed in one of the preceding Claims, characterised in that the chamber (15) of the case (1) is arranged outwards in order to accommodate an apparatus-specific additional electronics unit, and in order to accommodate connections between a plurality of such chambers when a plurality of cases are used, and in order to accommodate sealed connections, such as connection plugs (23).

6. A case as claimed in one of the preceding Claims, characterised in that threaded spindles (16) hinged to the two lateral walls (5) of the case (1) are externally arranged, which threaded spindles support captive knurled nuts (17) which on their part are respectively connected to a cam-shaped component (18) so as to be form-locking and rotatable, which component engages into a lateral slot (19) of a collar (20) on the drawer (4) by means of grooves (21) when the threaded spindle has been pivotted.

## Revendications

1. Coffret (1) à tiroir (4) pour des appareils de la technique électrique des communications, qui est pourvu de dispositifs électriques à enfichage (3) pour le tiroir (4), et dont les parois latérales (5) sont pourvues, pour des liaisons par vissage (7), d'appendices débordant vers l'extérieur; caractérisé par les moyens remarquables suivants:

a) le coffret (1) est constitué par un boîtier à fond (8) d'un seul tenant, par deux parois latérales (5) situées l'une en face de l'autre et par une paroi arrière (10),

b) le coffret (1) est susceptible d'être relié, par l'intermédiaire des liaisons par vissage (7) et sur le côté supérieur ouvert qui est situé en face du fond (8), à un couvercle (9) ou à un fond identique (8) d'un second coffret superposé,

c) le coffret (1) est pourvu d'une paroi intermédiaire (2) qui s'étend parallèlement à la paroi arrière et sur laquelle sont prévus les dispositifs électriques à enfichage (3) pour les tiroirs (4),

d) la paroi intermédiaire (2) est pourvue d'une collerette (22) fermée sur elle-même et entourant à la fois les dispositifs à enfichage (3), laquelle collerette étant prévue pour un cordon d'étanchéité et assumant l'étanchéité en coopération avec une collerette correspondante qui entoure les dispositifs d'enfichage du tiroir (4),

e) la chambre (15) qui est constituée par le fond (8), par les parois latérales (5), par la paroi arrière (10) et par la paroi intermédiaire (2), de même que par le couvercle vissé (9) sur le fond (8) d'un second coffret superposé, est rendue étanche à l'eau et éventuellement imperméable à des champs électromagnétiques, par des cordons d'étanchéité disposés dans des gorges (11) du bord (12), d'abord ouvert, du coffret (1).

2. Coffret selon la revendication 1, caractérisé par le fait que le tiroir (4), lui-même, et ses dispositifs à enfichage, sont rendus étanches par des cordons d'étanchéité.

3. Coffret selon l'une des revendications précédentes, caractérisé par le fait que dans la zone de l'étanchéité de la chambre, les appendices latéraux (13) prévus sur les parois latérales (5) sont élargis à la manière de flasques.

4. Coffret selon l'une des revendications précédentes, caractérisé par le fait que sur la paroi arrière (10) et sur la paroi intermédiaire (2) sont prévus, pour des liaisons par vissage (14a), d'autres appendices (14) qui débordent vers l'extérieur ou qui s'étendent vers le tiroir (4).

5. Coffret selon l'une des revendications précédentes, caractérisé par le fait que la chambre (15) du coffret (1) est prévue pour recevoir des électroniques supplémentaires et spécifiques aux appareils et, dans le cas de l'utilisation de plusieurs coffrets, pour recevoir des liaisons entre plusieurs chambres ainsi que pour recevoir des liaisons étanches telles que des fiches de branchement (23) vers l'extérieur.

6. Coffret selon l'une des revendications précédentes, caractérisé par le fait qu'à l'extérieur et sur les deux parois latérales (5) du coffret, sont prévues des broches (16) fixées à la manière de charnières, lesquelles broches portent des écrous crantés (17) qui à leur tour sont reliés, par formes complémentaires et de manière à pouvoir tourner, avec, respectivement, une partie (18) en forme de came, laquelle partie en forme de came pénétre, à l'aide de gorges (21), dans une fente latérale (19) d'une collerette (20) du tiroir (4), après basculement de la broche dans sa position rabattue.

0 049 517

FIG 1

FIG 2

1